# EUROPÄISCHE PATENTSCHRIFT

(11) **EP 0 428 673 B1**
(45) Veröffentlichungstag und Bekanntmachung des Hinweises auf die Patenterteilung: **13.09.1995**
(21) Anmeldenummer: 90908470.9
(22) Anmeldetag: 02.06.1990
(51) Int. Cl.: H01L 21/22

(54) **VERFAHREN ZUR HERSTELLUNG VON DOTIERTEN HALBLEITERSCHICHTEN**
PROCESS FOR MANUFACTURING DOPED SEMICONDUCTOR LAYERS
PROCEDE DE FABRICATION DE COUCHES SEMI-CONDUCTRICES DOPEES

(30) Priorität: 02.06.1989 DE 3918094
(43) Veröffentlichungstag der Anmeldung: 29.05.1991
(73) Patentinhaber: AIXTRON GMBH, 52072 Aachen (DE)
(72) Erfinder: JÜRGENSEN, Holger, D-5100 Aachen (DE)
(74) Vertreter: Münich, Wilhelm, Dr.
(86) Internationale Anmeldenummer: DE9000425
(87) Internationale Veröffentlichungsnummer: WO9015435

(56) Entgegenhaltungen:
- WO-A-81/03399
- US-A- 4 566 918
- APPLIED PHYSICS LETTERS, Band 53, Nr. 4, 25. Juli 1988, American Institute of Physics, (New York, NY, US), E.F. SCHUBERT et al.: "Diffusion of Atomic Silicon in Gallium Arsenide", Seiten 293-295
- PATENT ABSTRACTS OF JAPAN, Band 9, Nr. 75 (E-306) (1798), 4. April 1985; & JP-A-59 210 641

## Beschreibung

Die Erfindung bezieht sich auf ein Verfahren zur Herstellung von dotierten Halbleiterschichten mit einer niedrigen Ladungsträger-Konzentration.

Die Konzentration von n- bzw. p-Ladungsträgern in Halbleitermaterialien wird durch den Einbau von entsprechenden Dotierstoff-Elementen in das Grund-Kristallgitter eingestellt. Bei den üblicherweise verwendeten Verfahren zur Herstellung von dotierten Halbleiterschichten, bspw. VPE-, MOCVD-, LPE- oder MBE-Verfahren wird die Konzentration des Dotierstoffelements in der Umgebung des Substrats, auf dem die Schichtherstellung stattfindet, möglichst konstant gehalten. Das oder die Dotierstoffelemente werden dabei typischweise in Form von Gasen, Flüssigkeiten oder Molekularstrahlen angeboten.

Auf diese Weise wird über den Verteilungskoeffizienten zwischen Umgebungsmedium und Festkörper eine konstante Konzentration der Dotierstoff-Elemente im Festkörper, d.h. in der hergestellten Schicht, und damit eine konstante Ladungsträger-Konzentration eingestellt.

Bpsw. benötigt man zur Herstellung von GaInAs-Schichten mit einer Konzentration von 10¹⁶ Zink-Atomen pro cm³ einen Partialdruck der Zink-Verbindung von ca. 10⁻⁴ Pa (10⁻⁹ bar). Um dagegen eine Dotierstoff-Konzentration von 10¹⁵cm⁻³ einzustellen, wäre es erforderlich, den Partialdruck der Zink-Verbindungen auf einen Wert von weniger als 10⁻⁵ Pa (10⁻¹⁰ bar) einzustellen.

Aus der US A-4 566 918 ist ein Verfahren zur Herstellung von dotierten Halbleiterschichten in einem Schichtlaminat bekannt. Ein Verfahren zur Herstellung von dotierten Oxydschichten, die abwechselnd vergleichsweise hohe Ladungsträger-Konzentrationen und keine Dotierung aufweisen, wird in den Patent Abstracts of Japan, Bd. 9, Nr. 75, (E-306) (1798) vom 4. April 1985 und in der JP-A-59210641 offenbart.

Aus diesen Druckschriften ist allerdings nicht bekannt, Schichten mit einer niedrigen Ladungsträger-Konzentration mit großer Genauigkeit einzustellen.

Da bei den herkömmlichen Verfahren zur Herstellung von dotierten Halbleiterschichten der Partialdruck der Dotierstoff-Verbindungen während der gesamten Schicht-Herstellung konstant gehalten werden muß, ist zur Herstellung von Schichten mit einer niedrigen Ladungsträger-Konzentration bspw. im Bereich von 10¹⁵cm⁻³ ein sehr hoher technischer Aufwand erforderlich, ohne daß es gewährleistet wäre, die gewünschte Ladungsträger-Konzentration tatsächlich mit der erforderlichen Genauigkeit einzustellen.

Der Erfindung liegt die Aufgabe zugrunde, ein Verfahren zur Herstellung von dotierten Halbleiterschichten mit einer niedrigen Ladungsträger-Konzentration anzugeben, das mit einem vertretbaren Aufwand die Herstellung von niedrigen Ladungsträger-Konzentrationen, typischerweise im Bereich von weniger als 10¹⁶cm⁻³ erlaubt.

Eine erfindungsgemäße Lösung dieser Aufgabe ist im Anspruch 1 angegeben.

Die Erfindung geht von dem Grundgedanken aus, daß die Einstellung der gewünschten Ladungsträger-Konzentration nicht durch ein während der Schichtherstellung konstantes Angebot an Dotierstoff-Elementen, sondern durch eine Sequenz von typischerweise Rechteck-Dotierstoffprofilen und eine Durchschnittsbildung über die Dotierstoffprofile erfolgt.

Hierzu wird die gewünschte Schicht mit einer vorgegebenen, niedrigen Ladungsträger-Konzentration dadurch hergestellt, daß sie aus einer Vielzahl von wesentlich dünneren Schichten aufgebaut ist, die übereinander aufgebracht werden und abwechselnd eine vergleichsweise hohe Dotierstoff-Konzentration und damit eine vergleichsweise hohe Ladungsträger-Konzentration und keine Dotierung aufweisen. Die Dicke und die Ladungsträger-Konzentration der einzelnen Schichten sind derart bemessen, daß sich durch Mittelung "senkrecht zur Schichtoberfläche" über die Vielzahl von Schichten die gewünschte niedrige Ladungsträger-Konzentration ergibt.

Dabei werden unter dem Begriff "keine Dotierung" Bereiche verstanden, die durchaus eine sehr kleine Konzentration an Dotierstoff-Elementen aufweisen können, wie sie bspw. durch im Reaktionsgefäß aufgrund der Herstellung der "darunterliegenden Schicht" vorhandene Reststoffe entstehen. Entscheidend ist lediglich, daß die Dotierung in diesen Bereichen sowohl gegen die Dotierung der beabsichtigt dotierten Schichten als auch gegen die gewünschte Ladungsträger-Konzentration klein ist, so daß es auf eine exakte Einstellung der Konzentration in diesen Bereichen nicht "ankommt".

Das erfindungsgemäße Verfahren hat damit den Vorteil, daß es nicht erforderlich ist, die zur Herstellung niedriger Dotierstoff-Konzentration erforderlichen niedrigen Partialdrücke der Dotierstoff-Trägerverbindungen mit der erforderlichen Genauigkeit einzustellen. Vielmehr ist es lediglich erforderlich, in den dünnen Schichten mit einer vergleichsweisen hohen Ladungsträger- bzw. Dotierstoff-Konzentration den Partialdruck der für die Dotierung "angebotenen" Elemente in einem vergleichsweise hohen Druckbereich genau einzustellen.

Bei elektrischen Messungen mitteln sich nämlich die hoch- und niedrig-dotierten Bereiche, so daß ein Mittelwert gemessen wird, solange die Dicken der einzelnen Bereiche bzw. Schichten niedrig genug gewählt sind. Bspw. erhält man makroskopisch eine Schicht mit einer Dotierung von 10¹⁵cm⁻³, wenn 90% der Schicht undotiert sind und 10% der Schichtdicke eine Dotierung von 10¹⁶cm⁻³ aufweisen. Entsprechend wäre es bspw. auch möglich, 99% der Schichtdicke nicht zu dotieren und 1% der Schichtdicke mit einer Dotierung von 10¹⁷ cm⁻³ zu versehen.

In jedem Falle ist es jedoch erforderlich, die dotierten Bereiche gleichmäßig in die Gesamtschicht einzubringen.

Weiterbildungen der Erfindung sind in den Unteransprüchen angegeben:

Im Anspruch 2 sind bevorzugte Verfahren angegeben, die sich für die Herstellung des erfindungsgemäßen Schichtaufbaus besonders eignen. Ausdrücklich wird jedoch daraufhingewiesen, daß die im Anspruch 2 angegebene Aufzählung nicht abschließend ist.

Im Anspruch 3 ist ein bevorzugter Bereich des Verhältnisses der Dicke der undotierten Schichten zur Schichtdicke der dotierten Schichten angegeben. Wenn die Schichtdicke der undotierten Schichten um den Faktor 10 bis 100 größer als die Schichtdicke der dotierten Schichten ist, ist gewährleistet, daß der Partialdruck des Dotierstoffträgers auch bei sehr niedrigen Ladungsträger-Konzentrationen in einem technisch beherrschbaren Bereich liegt, da dann die dotierten Schichten eine um diesen Faktor höhere "Dotierung" aufweisen (Anspruch 7).

Im Anspruch 4 ist eine bevorzugte Schichtdicke der dotierten Schichten, nämlich zwischen einer "Monolage" und ca. 100 nm angegeben. Bei Einhalten dieser Schichtdicke ist gewährleistet, daß die Dicke der nicht-dotierten Schichten "nicht so groß" ist, daß eine Mittelung in Richtung der Dicke der Schicht über sämtliche Schichten ausgeschlossen wäre, so daß sich die Gesamtschicht "makroskopisch" so darstellt, als hätte sie eine homogene niedrige Ladungsträger-Konzentration.

Gemäß Anspruch 5 werden die Vielzahl von Schichten nach der Herstellung einer Wärmebehandlung unterzogen. Aufgrund des unterschiedlichen Diffusionsverhaltens der Dotierstoffe bei den verschiedenen Verfahren kann gegebenenfalls durch Nachtempern ein Verbessern der Homogenität erzielt werden.

Das erfindungsgemäße Verfahren eignet sich zur Herstellung niedriger Ladungsträger-Konzentrationen bei beliebigen Halbleitermaterialien, beispielsweise bei Halbleitern auf Si- oder Ge-Basis oder bei II-VI-Halbleitern. Besonders bevorzugt wird das erfindungsgemäße Verfahren jedoch bei III-V-Halbleitern zur Herstellung von Ladungsträger-Konzentrationen von weniger als 10¹⁶ cm⁻³ eingesetzt (Anspruch 6).

Die Erfindung wird nachstehend anhand von Ausführungsbeispielen unter Bezugnahme auf die Zeichnung exemplarisch beschrieben, auf die im übrigen bezüglich der Offenbarung aller im Text nicht näher erläuterten erfindungsgemäßen Einzelheiten ausdrücklich verwiesen wird. Es zeigen:
- Fig. 1: die Dotierstoff-Konzentration als Funktion des Partialdrucks während der Schichtherstellung,
- Fig. 2: eine schematische Darstellung des Schichtaufbaus.

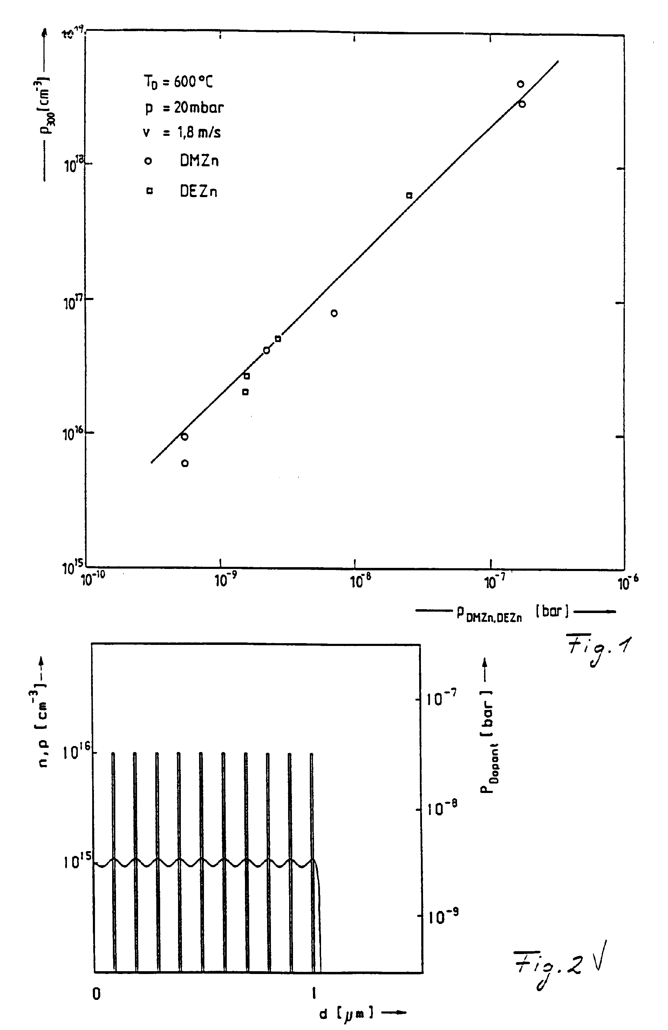

Fig. 1 zeigt die Dotierstoff-Konzentration (aufgetragen auf der Ordinate in Atomen/cm³) als Funktion des Partialdrucks des Dotierstoff-Trägers (aufgetragen auf der Abzisse in bar) (1 bar = ca. 10⁵ Pa) exemplarisch für den Einbau von Zink aus DMZn oder DMZn-Verbindungen in GaInAs. Die Prozeßparameter sind dabei in Fig. 1 angegeben. Mit p=2x10³ Pa (20 mbar) ist der in der Prozeßkammer vorhandene Gesamtdruck gemeint.

Fig. 1 ist zu entnehmen, daß zur Herstellung sehr niedriger Dotierstoff-Konzentrationen von weniger als 10¹⁶ cm⁻³ sehr niedrige Partialdrücke im Bereich von weniger als 10⁻⁴ Pa (10⁻⁹ bar) eingestellt werden müssen. Die Einstellung und Konstanthaltung derart niedriger Partialdrücke ist technisch sehr aufwendig und in der Praxis häufig nicht zu realisieren.

Deshalb wird erfindungsgemäß die gewünschte niedrige Ladungträger-Konzentration von bspw. 10¹⁵ cm⁻³ dadurch eingestellt, daß nacheinander eine Vielzahl von dünnen Schichten aufgebracht werden, die abwechselnd vergleichsweise hohe Ladungsträger-Konzentrationen und keine Dotierung aufweisen.

Fig. 2 zeigt schematisch den Aufbau einer Schicht mit einer Dicke von 1µ, und mit ei-ner "mittleren" Ladungsträger-Konzentration von 10¹⁵cm⁻³: Die Schicht besteht in Richtung senkrecht zur Schicht-Oberfläche aus einer Vielzahl von wesentlich dünneren Schichten, von denen jede zweite Schicht eine Ladungsträger-Konzentration von etwa 10¹⁶cm⁻³ aufweist. Diese dotierten Schichten sind durch etwa um den Faktor 10 dickere Schichten ohne Dotierung voneinander getrennt. Insgesamt stellt sich dieses "Schichtlaminat" makroskopisch so dar, als wäre es eine "weitgehend homogene" Schicht mit einer Ladungsträger-Konzentration von etwa 10¹⁵cm⁻³. Auf der rechten Ordinate in Fig. 2 sind die zur Herstellung von entsprechenden Schichten erforderlichen Partialdrücke angegeben: Zur Herstellung der dünnen "Zwischenschichten" mit einer Ladungsträger-Konzentration von 10¹⁶cm⁻³ kann der Partialdruck an Dotierstoff-Trägerverbindungen wenigstens um den Faktor 10 größer sein, als es für die Herstellung einer homogenen Schicht mit einer Ladungsträger-Konzentration von 10¹⁵cm⁻³ erforderlich wäre. Damit ist die Druckeinstellung und die Konstanthaltung des Drucks entsprechend einfacher.

Vorstehend ist die Erfindung anhand eines Ausführungsbeispiels beschrieben worden. Insbesondere kann das erfindungsgemäße Verfahren auch für andere Dotier- bzw. Schichtherstellungsverfahren, Dotierstoffe und Grundmaterialien, wie Halbleiter aus Silizium- oder Germanium-Basis oder für II-VI-Halbleiter verwendet werden.

Auch ist die Ladungsträger-Konzentration, die als niedrig im Sinne der vorliegenden Erfindung anzusehen ist, vom verwendeten Grundmaterial abhängig. Ferner ist die Dotierungs-Konzentration der sog. hoch-dotierten Schichten abhängig von dem jeweiligs verwendeten Herstellungsverfahren und den jeweiligen Austauschkoeffizienten.

## Patentansprüche

1. Verfahren zur Herstellung eines dotierten Halbleiterschichtlaminats,
dadurch **gekennzeichnet**, daß eine Vielzahl von Halbleiterschichten aufeinander aufgebracht werden, die abwechselnd vergleichsweise hohe Ladungsträger-Konzentrationen und keine Dotierung aufweisen, und
daß die Dicke und die Ladungsträger-Konzentration der einzelnen Schichten derart bemessen sind, daß sich durch Mittelung senkrecht zur Oberfläche des Schichtlaminats über die Vielzahl der Schichten eine Ladungsträger-Konzentration von < 10¹⁶ cm⁻³ ergibt.

2. Verfahren nach Anspruch 1,
dadurch **gekennzeichnet**, daß die Dotierung mit einem MOCVD- VPE-, LPE- oder MBE-Verfahren erfolgt.

3. Verfahren nach Anspruch 1 oder 2,
dadurch **gekennzeichnet**, daß die Schichtdicke der undotierten Schichten um den Faktor 10 bis 100 größer ist als die Schichtdicke der dotierten Schichten.

4. Verfahren nach einem der Ansprüche 1 bis 3,
dadurch **gekennzeichnet**, daß die Schichtdicke der dotierten Schichten zwischen einer "Monolage" und 100 nm beträgt.

5. Verfahren nach einem der Ansprüche 1 bis 4,
dadurch **gekennzeichnet**, daß die Vielzahl von Schichten nach der Herstellung einer Wärmebehandlung unterzogen werden.

6. Verfahren nach einem der Ansprüche 1 bis 5,
dadurch **gekennzeichnet**, daß das Grundmaterial ein III-V-Halbleiter ist.

7. Verfahren nach einem der Ansprüche 1 bis 6,
dadurch **gekennzeichnet**, daß die vergleichsweise hohe Konzentration an Dotierstoffen um den Faktor 10 bis 100 größer als die gemittelte Ladungsträger-Konzentration ist.

## Claims

1. A process for producing a doped laminate of semiconductor layers,
wherein a multiplicity of thin layers are applied on top of each other having alternately comparatively high concentrations of charge carriers and no doping and the thickness and the concentration of charge carriers of the individual layers is proportioned in such a manner that a charge carrier concentration of <10¹⁶ cm⁻³ is yielded by orthogonally averaging to the surface of the layer laminate over the multiplicity of the layers.

2. A process according to claim 1,
wherein said doping occurs with a MOCVD, VPE, LPE or MBE process.

3. A process according to claim 1 or 2,
wherein the layer thickness of the not doped layers is greater by the factor 10 to 100 than the layer thickness of the doped layers.

4. A process according to one of the claims 1 to 3,
wherein the layer thickness of said doped layers is between one "mono-layer" and approx. 100 nm.

5. A process according to one of the claims 1 to 4,
wherein said multiplicity of layers undergo a thermal treatment following production.

6. A process according to one of the claims 1 to 5,
wherein said base material is a III-V semiconductor.

7. A process according to one of the claims 1 to 6,
wherein the relatively high concentration of doping materials is larger by the factor 10 to 100 than said desired low concentration of charge carriers.

## Revendications

1. Procédé de fabrication d'un aggloméré stratifié à couches se mi-conductrices dopées,
**caractérisé** en ce qu'une pluralité de couches semi-conductrices sont empilées l'une sur l'autre, qui, de façon alternative, présentent soit des concentrations relativement hautes de porteurs de charge, soit aucun dopage, et
en ce que l'épaisseur et la concentration desdits porteurs de charge desdites couches séparées sont dimensionnées de façon qu'en faisant la moyenne en sens orthogonal sur la surface dudit aggloméré stratifié, à travers ladite pluralité de couches, on obtient une concentration de porteurs de charge de < 10¹⁶ cm⁻³.

2. Procédé selon la Revendication 1,
**caractérisé** en ce que le dopage se fait par un processus dit MOCVD, VPE, LPE ou MBE.

3. Procédé selon la Revendication 1 ou 2,
**caractérisé** en ce que l'épaisseur desdits couches non dopées est plus grand, par un facteur de 10 à 100, que l'épaisseur desdites couches dopées.

4. Procédé selon une quelconque des Revendications 1 à 3,
**caractérisé** en ce que la valeur de l'épaisseur desdites couches dopées se trouve entre un "mono-pli" et 100 nm.

5. Procédé selon une quelconque des Revendications 1 à 4,
**caractérisé** en ce qu'après la fabrication, la pluralité desdites couches est soumise à un traitement thermique.

6. Précédé selon une quelconque des Revendications 1 à 5,
**caractérisé** en ce que le matériau de base est un semi-conducteur III-V.

7. Procédé selon une quelconque des Revendications 1 à 6,
**caractérisé** en ce que concentration relativement haute des substances de dopage est plus haute, par un facteur de 10 à 100, que la concentration moyenne des porteurs de charge.
